# EUROPEAN PATENT APPLICATION

(11) **EP 2 618 392 A2**
(43) Date of publication of application: **24.07.2013**
(21) Application number: 13152382.1
(22) Date of filing: 23.01.2013
(51) Int. Cl.: H01L 33/54

(54) **Light Emitting Diode with Improved Directionality**

(30) Priority: 23.01.2012 US 201213355644
(71) Applicant: Sharp Kabushiki Kaisha, Osaka-shi, Osaka 545-8522 (JP)
(72) Inventor: Tan, WeiSin, Oxford, Oxfordshire OX4 4GB (GB); Brockley, Michael John, Oxford, Oxfordshire OX4 4GB (GB); Berryman-Bousquet, Valerie, Oxford, Oxfordshire OX4 4GB (GB)
(74) Representative: Suckling, Andrew Michael

(57) **Abstract**

A light emitting diode (LED) is provided that includes a host substrate (1) formed from a first material, an n-type layer (2a) formed over the host substrate, an active region (3) formed over the n-type layer, and a p-type layer (2b) formed over the active region. A layer (6) is formed adjacent to the host substrate and includes a second material, the second material being different from the first material or having a refractive index different from a refractive index of the first material. Further, the second material is formed with a tapered outwards sidewall profile.

## Description

### TECHNICAL FIELD OF THE INVENTION

The present invention relates to a light emitting diode (LED) device and a method of making the same, and in particular an LED device structure with tapered outwards sidewalls, with the tapered portion made of a different material to that of the LED host substrate.

### BACKGROUND OF THE INVENTION

In recent years, the use of light emitting diodes (LED) as a light source to replace incandescent bulbs and compact fluorescent lamps (CFL) for general lighting and backlight applications is becoming increasingly popular. LEDs have the advantage of higher efficiency over conventional light sources and the use of non-toxic materials. Research laboratories have reported LEDs with efficacies of 200 Im/W, while commercially available chips are currently yielding ∼ 100 1m/W. Theoretically, the maximum efficacy of an LED chip is between 300 - 400 1m/W, thus there is still plenty of room for further improvement.

An indium gallium nitride-based (InGaN) blue LED chip emitting at ∼ 440 - 460nm is typically used to excite a phosphor layer to create white light LED. The overall efficiency of an LED is determined by its external quantum efficiency (EQE), which is the product of the internal quantum efficiency (IQE) and light extraction efficiency (LEE). The IQE is determined by the quality of the active region and values above 85% have been reported. However, LEE is a major problem for nitride-based LEDs. Due to the large refractive index contrast between GaN (*n* ∼ 2.5) and air, the majority of generated light has difficulty escaping the structure and is waveguided within the semiconductor layer itself, resulting in subsequent absorption. The LEE of a conventional LED chip without any special light extraction features is only ∼25-30%. To increase LEE, methods such as patterned sapphire substrates, photonic crystal, flip-chip mounting and chip shaping has been employed, and LEE values of a typical commercial LED ship is ∼60-70%.

The other issue related to LEE is the light directionality. Due to waveguiding effect, more than 50% of the light escapes the LED structure through the sidewalls of the chip. Light escaping through the sidewalls has a high probability of being directed downwards to the package reflector, resulting in a strong influence of the package reflectivity on chip LEE. Therefore, while an LED chip itself may have good LEE properties, the nature of its high ratio of downward emission would result in package reflectivity ultimately dictating the chip performance. It is therefore highly desirable for most of the light to be emitted directly upwards.

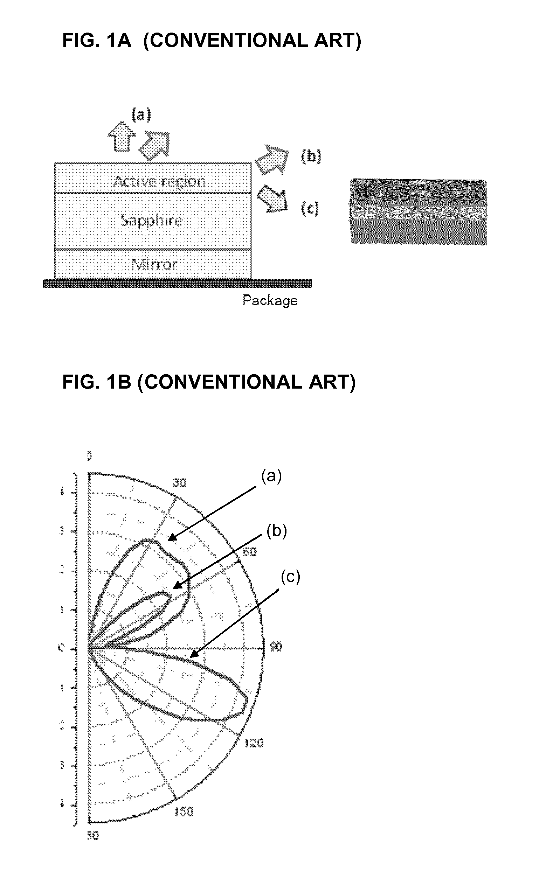

**FIG. 1A** shows three different routes for light to escape a *p*-side up mounted LED structure (meaning the LED is mounted on a package and the *p*-layer of the LED structure is facing away from this package): upwards from the top surface (A), upwards from the sidewalls (B) and downwards from the sidewalls (C) for a typical flat vertical sidewall LED chip as shown in the inset. In **FIG. 1B****,** the simulated far-field light emission profile of an LED chip with typical 130µm thick sapphire substrate is shown. Note that all simulation results are performed in a resin encapsulation ambient unless stated otherwise. Observe that C emission ratio represents more than 50% of the overall chip emission. In general, a thicker sapphire substrate will lead to even higher C emission ratio due to larger sidewall chip area.

Reducing sapphire thickness will reduce C emission ratio, but LED chips thinner than 100µm become difficult to handle in manufacturing environment. Sidewall emission can also be reduced by using flip chip *p*-side down (whereby the LED is mounted on a package and the p-layer is facing towards this package) mounting with sapphire substrate removed [O. Shchekin et. al, Applied Physics Letters, vol. 89, pp. 071109 (2006)]. However, this process is more expensive and complicated over conventional *p*-side up mounting.

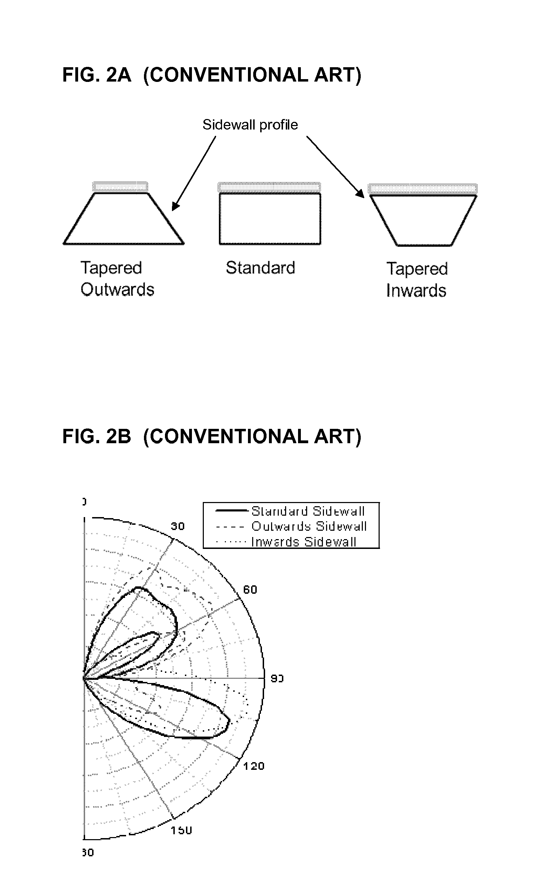

Another method to alter the directionality of a *p*-side up mounted LED is by substrate shaping. **FIG. 2A** shows three different sapphire substrate sidewall profiles and the resulting calculated far-field light emission directionality are shown in **FIG. 2****B.** From the graph, C emission is much reduced when the sidewalls are tapered outwards, while C emission increases for tapered inwards sidewalls. Therefore, tapered outwards sidewall will be most preferable structure to reduce C emission.

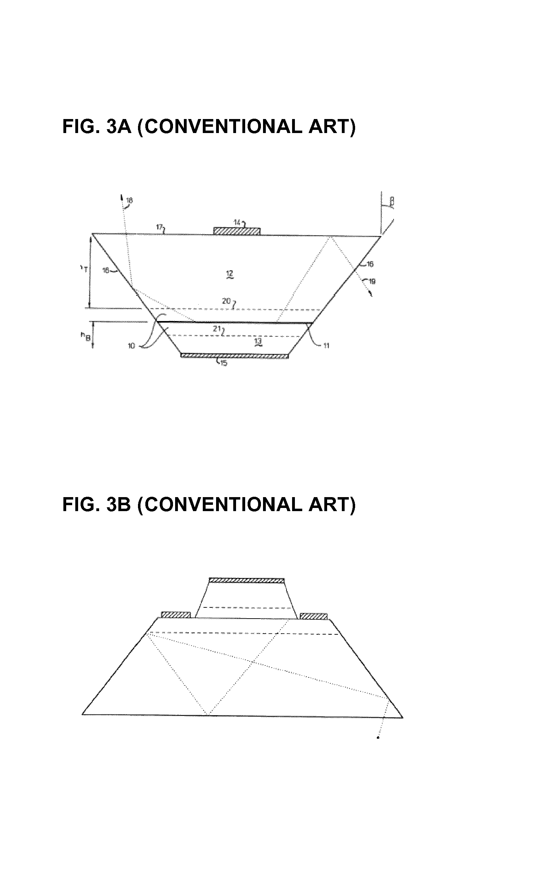

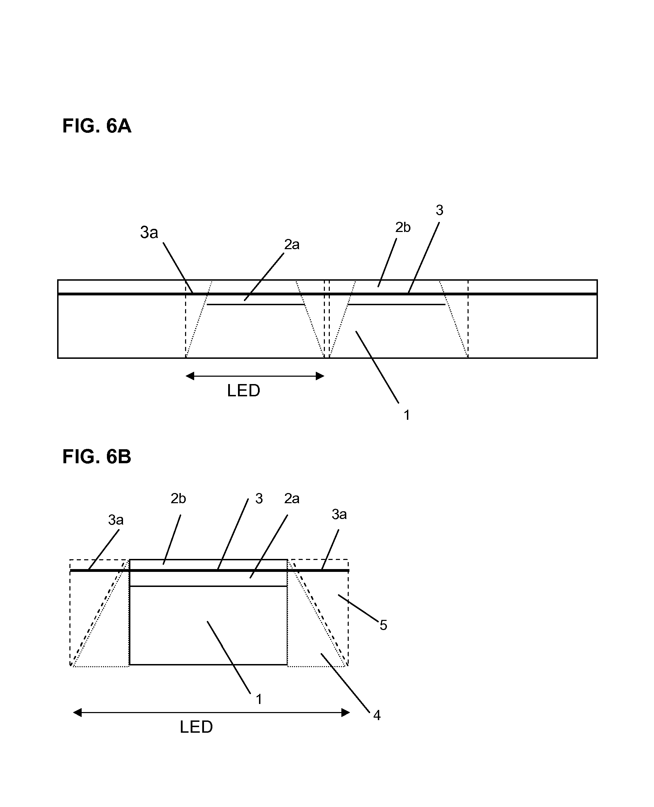

The use of tapered inwards (**FIG. 3A**) and tapered outwards (**FIG. 3B**) substrate structure to improve light extraction efficiency is described by Krames et al. in US 6,323,063 (November 27, 2001). Both structures described by the author are obtained by shaping the LED host substrate (Host substrate is defined as the substrate whereby the epilayer is grown). As shown in **FIG. 2B** for tapered inwards structure, light extraction through C emission is increased; therefore, this structure would be more suitable if package reflectivity is high (i.e. >90%). However, there are high costs associated with producing LED package with very high reflectivity. For tapered outwards structure, C emission is much reduced therefore this structure is advantageous if package reflectivity is not so high. Manufacturing a tapered outwards structure will result in a significant loss of active area, since the active region on the tapered sapphire areas is wasted (refer to **FIG. 6A**). As a result, it may not be economically viable to manufacture such a structure.

In US 5,087,949 (February 11, 1992) (**FIG. 4**), Haitz *et* Al., teaches the concept of forming V-Grooves on the *n*-side of the substrate, and the LED is subsequently *p*-side down mounted. Therefore, the substrate has a tapered outwards shape with this method but active region area is not wasted in the manufacturing process. *P*-side down mounting process is however more complex in manufacturing environment over *p*-side up structures.

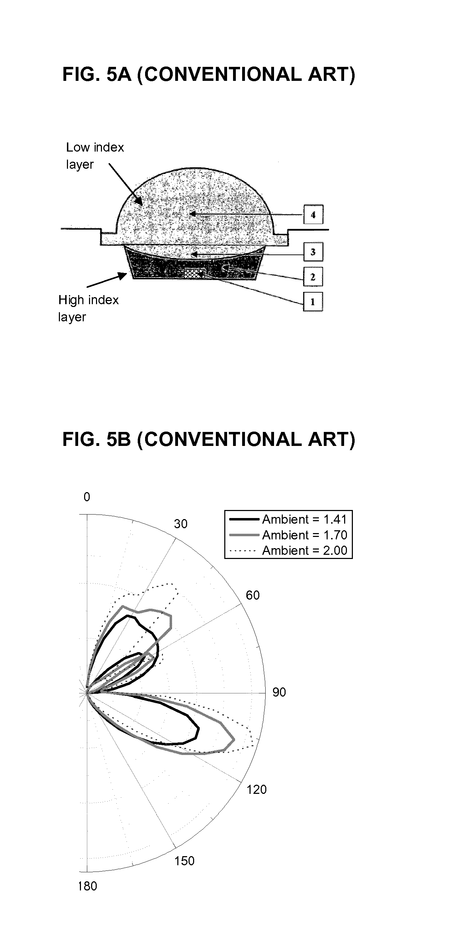

In **FIG. 5A****,** Taskar et Al. (US 2006/0255353 - November 16, 2006), describes the use of a high refractive index layer encapsulating the entire LED chip, followed by a low refractive index film deposited on top of the high index film. High index films/resin/epoxy is more effective for light extraction, but is also more expensive than low index films. By encapsulating an LED in a high index film, light extraction is improved by increasing C emission through sidewalls of the chips. This method is therefore still reliant on package reflectivity being high in order to achieve overall high extraction efficiency. **FIG. 5B** illustrates this whereby higher refractive index material (described as Ambient *n* = 1.7 or 2 in **FIG. 5B**) used to encapsulate the LEDs will result in greater sidewall emission.

From the examples above, it is evident that there is a need in the art for LED devices with good forward emission directionality without compromising manufacturing costs.

### SUMMARY OF THE INVENTION

A device and method in accordance with the present invention provide a *p*-side up mounted LED chip with reduced C emission by forming a tapered outwards sidewall structure using a different material to that of the host substrate. This approach does not result in wastage of LED chip area. As used herein, an LED chip is defined as a semiconductor that emits light, including the substrate that the semiconductor is formed on. Further, as used herein a tapered outwards sidewall profile or tapered outwards sidewall structure is defined as a configuration whereby the base area is larger than the area at the top.

The device and method in accordance with the present invention provide an LED structure with good forward emission directionality, resulting in improved overall light extraction efficiency. The device and method in accordance with the present invention include a tapered outwards sidewall structure formed on the host substrate and the method of making such a structure is also described.

An aspect of the invention is for the LED to have a tapered outwards substrate structure, and the tapered portion is formed using a different material or refractive index to that of the host substrate. The resulting LED chip has reduced C emission without LED active area wastage.

According to another aspect of the invention, the tapered outwards portion results in an LED chip with a trapezium-like shape, but the invention structure is not limited to a trapezium shape and can take any shape in general.

According to another aspect of the invention, the refractive index of tapered sidewalls portion is within 0.1 of the refractive index of the host substrate.

In accordance with another aspect of the invention, the refractive index of the tapered sidewalls portion is at least 0.1 less than the refractive index of the host substrate.

In accordance with still another aspect of the invention, the refractive index of the tapered sidewall portion is at least 0.5 less than the refractive index of the host substrate.

With yet another aspect of the invention, the refractive index of the tapered outwards sidewall can be made of a series of different refractive index materials.

In yet another aspect of the invention, the tapered outwards sidewall is made of a series of different refractive index material, graded from high index to low index material, whereby the refractive index of the host substrate is referenced as the high index material.

According to another aspect of the invention, the tapered sidewall portion is in the form of an air gap, sandwiched by epoxy or resin.

According to another aspect of the invention, a method is provided for fabricating the tapered outwards sidewall light emitting diode structure. The method includes first dicing/singulating individual LED chips with straight sidewalls from the wafer; depositing an index matching liquid/resin film to planarise the LED structure and its surroundings; dry etching of the structure to planarise and achieve desired height of the index matching resin; curing the resin if required; using a bevel blade or other means to shape the sidewalls of the LED.

In accordance to yet another aspect of the invention, another method is provided for fabricating the tapered outwards sidewall light emitting diode structure. The method includes having tapered outwards structure resembling pocket-like structures formed on the LED module package. Conventional LEDs with straight sidewalls are then inserted into these pockets and an index matching resin used to bond and create an intimate contact between the LED and pocket structures. According to one aspect of the invention, a light emitting diode (LED), includes: a host substrate formed from a first material; an n-type layer formed over the host substrate; an active region formed over the n-type layer; an p-type layer formed over the active region; and a layer formed adjacent to the host substrate and comprising a second material, the second material being different from the first material or having a refractive index different from a refractive index of the first material, wherein the second material is formed with a tapered outwards sidewall profile.

According to one aspect of the invention, a refractive index of the second material is within 0.1 of a refractive index of the first material.

According to one aspect of the invention, a refractive index of the second material is at least 0.1 less than a refractive index of the first material.

According to one aspect of the invention, a refractive index of the second material is at least 0.5 less than a refractive index of first material.

According to one aspect of the invention, the LED further includes base layer, wherein the host substrate is arranged over the base layer, and the second material is preformed on the base layer prior to the host substrate being arranged over the base layer.

According to one aspect of the invention, the base layer and the second material are formed from at least one of the same materials or different materials.

According to one aspect of the invention, a refractive index of the second material is defined by a series of different refractive index materials.

According to one aspect of the invention, the second material is formed from a plurality of different materials each having a refractive index, the plurality of different materials arranged one over the other from a high refractive index material to a low refractive index material, and wherein a refractive index of the host substrate is referenced as the high index material.

According to one aspect of the invention, the tapered outwards sidewall profile comprises a trapezium-like shape.

According to one aspect of the invention, the second material is formed from an optically transparent material.

According to one aspect of the invention,a refractive index of the second material is between 1.6 - 1.8 at 450nm.

According to one aspect of the invention, the tapered outwards sidewall profile comprises an air gap surrounded by epoxy or resin.

According to one aspect of the invention, a method for forming an LED device includes: mounting an LED chip onto an LED package base (14), the LED chip including a substrate (1), an n-type layer (2a), active region (3) and a p-type layer (2b); depositing a transparent layer onto the substrate (6), said transparent layer being a material different from the LED chip or having a refractive index different from a refractive index of the LED chip; and shaping the sidewalls of the transparent layer to form a tapered outwards sidewall profile.

According to one aspect of the invention, the method includes removing a portion of the transparent layer that lies over the LED chip.

According to one aspect of the invention, removing includes removing the portion via an etching process.

According to one aspect of the invention, depositing the transparent layer includes using a resin to form the transparent layer.

According to one aspect of the invention, depositing the transparent layer comprises curing the transparent layer.

According to one aspect of the invention, mounting the LED chip includes mounting the LED chip on a sacrificial substrate.

According to one aspect of the invention, mounting the LED chip comprises mounting a single LED chip or an array of LED chips.

According to one aspect of the invention, shaping the sidewalls includes shaping via a mechanical process, an optical process, or an etching process.

According to one aspect of the invention, a method for creating an LED device includes: forming sidewall structures (13) on an LED package base (14), said sidewall structures spaced apart from one another and comprising a tapered outwards sidewall profile; and inserting an LED chip between adjacent formed sidewall structures, said LED chip comprising non-tapered sidewalls.

According to one aspect of the invention, the method includes depositing a filler material between the LED chip and sidewall structures adjacent to the LED chip.

According to one aspect of the invention, depositing the filler material includes depositing a resin that is index matching to one of an LED host substrate of the LED chip or the sidewall structures.

To the accomplishment of the foregoing and related ends, the invention, then, comprises the features hereinafter fully described and particularly pointed out in the claims. The following description and the annexed drawings set forth in detail certain illustrative embodiments of the invention. These embodiments are indicative, however, of but a few of the various ways in which the principles of the invention may be employed. Other objects, advantages and novel features of the invention will become apparent from the following detailed description of the invention when considered in conjunction with the drawings.

### BRIEF DESCRIPTION OF THE DRAWINGS

In the annexed drawings, like references indicate like parts or features:
**FIGS. 1A and 1B** are schematic diagrams illustrating the different emission directions out of an LED and the resulting simulated far-field light profile of each emission direction;
**FIGS. 2A and 2B** are illustration of different sapphire sidewall structures and their respective far-field emission profiles obtained by optical simulation;
**FIGS. 3A and 3B** are known LED structures;

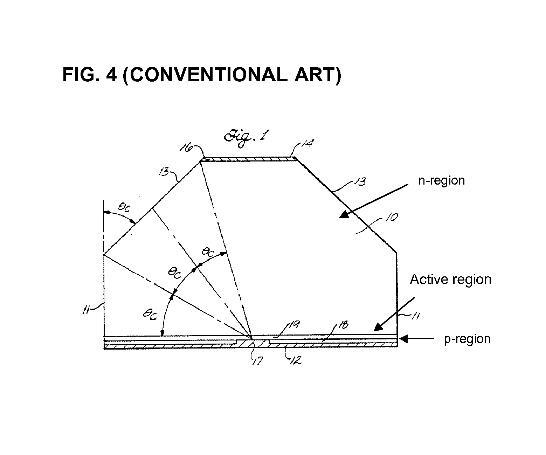

**FIG. 4** is another known LED structure;
**FIG. 5A** is yet another known LED structure and **FIG. 5B** is resulting simulated far-field light profile of LED chip in different encapsulant resin;
**FIGS. 6A and 6B** are schematic diagrams of a conventional manufacturing process for tapered sidewall LED device;
**FIG. 7** is an exemplary cross sectional view of an LED structure according to Embodiment 1;
**FIGS. 8A through 8C** are schematic diagrams of different invention designs and resulting improvement in LEE obtained by optical simulation;
**FIG. 9** is a cross sectional view for another version of an exemplary device in accordance with the invention, as described in Embodiment 2;
**FIG. 10** is a schematic diagram of an exemplary LED structure, according to Embodiment 3 of the invention;
**FIGS. 11A and 11B** are schematic diagrams of an LED and its far-field emission profile according to Embodiment 4 of the invention;
**FIGS. 12A through 12E** are cross sectional views illustrating a method of manufacturing the light emitting diode structure, according to Embodiment 5 of the present invention; and
**FIGS. 13A through 13C** are cross sectional views illustrating a method of manufacturing the light emitting diode structure according to embodiment 6 of the invention.

### DETAILED DESCRIPTION OF THE INVENTION

A device and method in accordance with the present invention provide an LED device with good forward emission characteristic. The LED structure includes a tapered outwards profile on the substrate region, and the tapered region is made from a different material (e.g., a second material) to that of the host substrate (e.g., a first material) or has a different refractive index from the host substrate. This approach does not lead to LED material wastage, as in the case of a conventional approach. The device and method in accordance with the invention will be detailed through the description of embodiments, wherein like reference numerals are used to refer to like elements throughout.

According to the invention, an LED with high ratio of forward emission to backward emission can be achieved without compromising useable active chip area. As depicted in **FIGS. 1A and 1B****,** the performance of an LED chip can be strongly affected by the package reflectivity. In a conventional LED chip with straight sidewalls, over 50% of light escapes the chip through downward C emission from the sidewalls of the chip. Considering that the package reflectivity of a conventional LED chip is only between 60-85%, the magnitude of downward emission will have a strong influence on the overall LED package efficiency. Therefore, an LED chip with small ratio of downward emission will be preferred, since package reflectivity would have a smaller impact on overall chip in package efficiency. From **FIGS. 2A** and **2B****,** it is evident that a tapered outwards sidewall is the best approach for achieving the desired result.

**FIG. 6A** shows an example of the LED device structure that includes a substrate **1,** an n-type layer **2a,** an active region **3,** and a p-type layer **2b.** LED devices are initially fabricated on a large area substrate and then singulated into individual LED chips (**LED** in **FIG.6A**). To form a tapered outwards structure **4** of the LED chip (**FIG. 6B**) described in the prior art, the sapphire substrate is shaped by using a dicing saw or stealth/ablation laser, resulting in a loss of chip area in region **5.** Therefore LED chip area on region **3a** will be wasted. As a result, it is not economical viable to produce LED chips with tapered outwards structure described in the art.

The tapered outwards portion can be in the form of a trapezium-like shape, but the inventive structure is not limited to a trapezium shape and can take any shape in general. In one embodiment the refractive index of tapered sidewalls portion (e.g., a second material) is within 0.1 of the refractive index of the host substrate (e.g., a first material). In another embodiment the refractive index of the tapered sidewalls portion is at least 0.1 less than the refractive index of the host substrate, or at least 0.5 less than the refractive index of the host substrate. The taper angle is equal to the difference between a right angle (90 degrees) and the angle formed where the material forming the tapered portion meets the top of the LED chip.

### Embodiment 1:

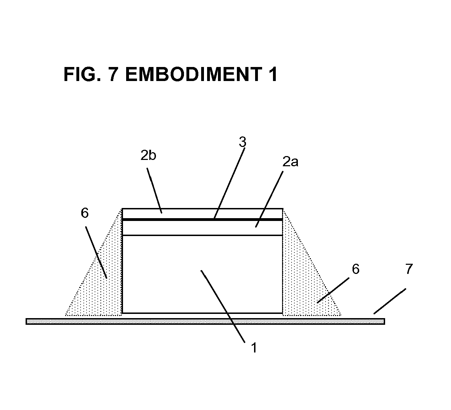

**FIG. 7** illustrates an exemplary device structure in accordance with first embodiment (Embodiment 1) of the invention. The tapered outwards portion of the structure 6 (also referred to as layer 6) is made from the different material (a second material) to that of the host substrate (a first material). The tip of the tapered outwards region can be higher, lower or similar to the LED chip. The reflector base of the LED package **7** is an imaginary layer where the LED is typically mounted. The refractive index of the tapered outwards portion **6** is ideally similar to the host substrate (refractive index of sapphire is ∼1.77 @450nm). Examples of transparent material in this refractive index range that can be used include SiOₓN_{y}, Optindex D54, Norland adhesives or other materials. However, this material can also be of lower refractive index than the host material. It is important to note that the inventive approach has a significantly different concept to the prior art structure described in **FIG. 5A****.** The method of encapsulating the LED with a high index material results in higher C emission, but the inventive concept acts to suppress C emission through shaping of a tapered outwards structure on the LED chip.

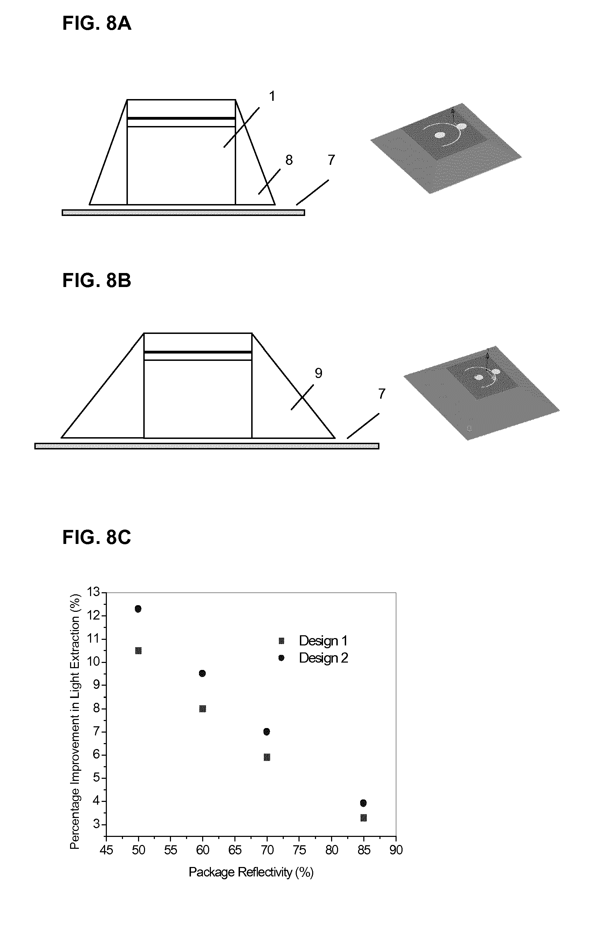

**FIGS. 8** show an example of two different sidewall profiles, with the structure in **FIG. 8A** (Design 1) having a smaller taper **8,** compared to the wider sidewall taper **9** for **FIG. 8B** (Design 2). The inset shows the 3D image for both structures. For this illustration, the refractive index of the tapered outwards portion **8** and **9** is made to be similar to that host substrate. In general, having a wider sidewall taper would improve light extraction efficiency due to further reduced C emission. In **FIG. 8C****,** simulation results are shown. They show improvement in light extraction efficiency over an LED structure with straight sidewalls described in **FIG. 1A****.** Also included are results for different values of package **7** reflectivity. **FIG. 8C** illustrates the improvement in light extraction efficiency that can be expected from both structures, and a better improvement is obtained from Design 2 over Design 1 due to the wider sidewall taper. Optimisation of the taper dimensions is dependent on both the chip size and also substrate thickness.

### Embodiment 2:

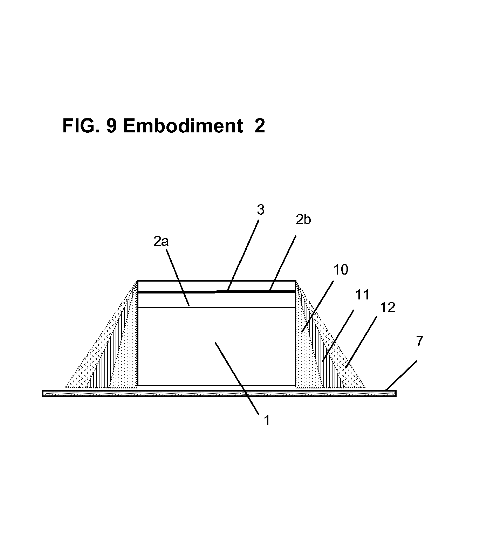

**FIG. 9** is an illustration of a second embodiment (Embodiment 2) in accordance with the invention. For this structure, the tapered outwards structure is made from a series of material (i.e., a plurality of materials) with different refractive indices. As example, layer **10** will have a similar or lower refractive index than the host substrate **1,** and layer **11** a lower refractive index than layer **10,** and layer **12** being lower than layer **11** (the materials are arranged one over the other from a high refractive index material to a low refractive index material). Any number of layers for the tapered outwards portion can be used in this structure, with any combination of refractive indices. It is not necessary for the refractive index to be graded or to follow a particular trend. In theory, by grading the refractive index from high to low moving outwards of the structure can further improve LEE.

### Embodiment 3:

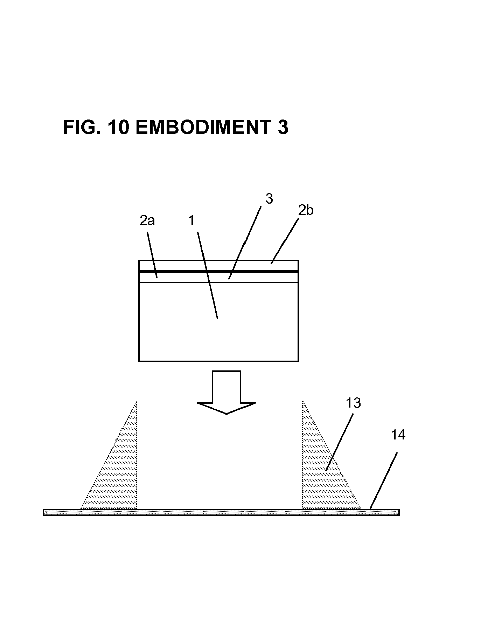

**FIG. 10** is an illustration of a third embodiment (Embodiment 3) in accordance with the invention. For this structure, the tapered outwards structure is formed externally on the LED package or reflector side, the LED package including a base formed from a first material and the tapered structure formed from a second material. This approach has the added advantage of not having to shape the LED sidewalls, therefore simplifying the manufacturing process. Instead of forming the tapered outwards portion on the LED chip, the tapered outwards structure **13** is pre-formed on the LED module package base **14** (also referred to as a base layer), for example as pocket columns (e.g., preformed sidewalls into which the LED package may be inserted - the sidewalls including the second material are pre-formed prior to the host substrate being arranged over the base layer). In the case of a high power LED module, a series of pockets are then formed on the package base. It is not essential for the height of the pocket structure to be similar to that of the LED chip. The tapered sidewall **13** is ideally transparent and can be made of the same or different material to the package base **14** (e.g., the second material may be the same material or different material from a base layers). It is preferable that a high index material between 1.6 - 1.8 @ 450nm is used for tapered sidewall **13,** but can also be of other values. A variety of methods can be used to form these structures, such as plastic injection mold techniques. The LED chips are then inserted into these pockets (e.g., the host substrate is arranged over the base layer) and can be followed by depositing a resin to fill possible gaps between the LED and pocket sidewall, subsequently making an intimate bond between the two materials. This embodiment benefits from not having to process the LED chips which have been diced/singulated into individual LED chips.

### Embodiment 4:

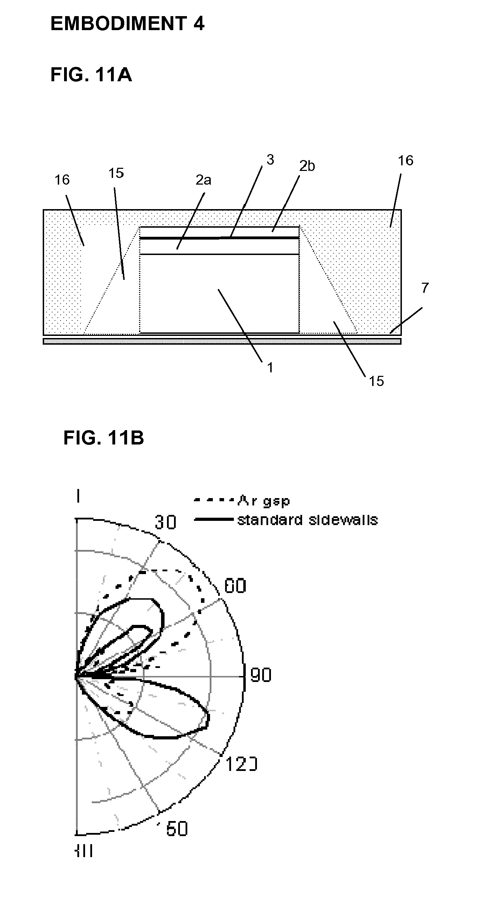

**FIG. 11A** is an illustration of fourth embodiment in accordance with the invention. For this structure, the tapered outwards structure **15** is an air pocket region, which is surrounded typically by LED epoxy or resin **16.** The air pocket region does not need to be shaped in a tapered outwards manner, and can be of any shape in general, and is surrounded by a material of different refractive index such as layer **16.** **FIG. 11B** compares the far-field light emission profile for this embodiment with a conventional LED structure. From the graph, C emission is reduced, and a subsequent improvement in forward emission achieved.

### Embodiment 5:

A manufacturing method in accordance with the present invention for embodiment 1 will be described. It is noted that the drawings are not to scale. The method sequences described however do not represent a complete fabrication process for the respective chip, but rather represent those germane to the method in accordance with the present invention.

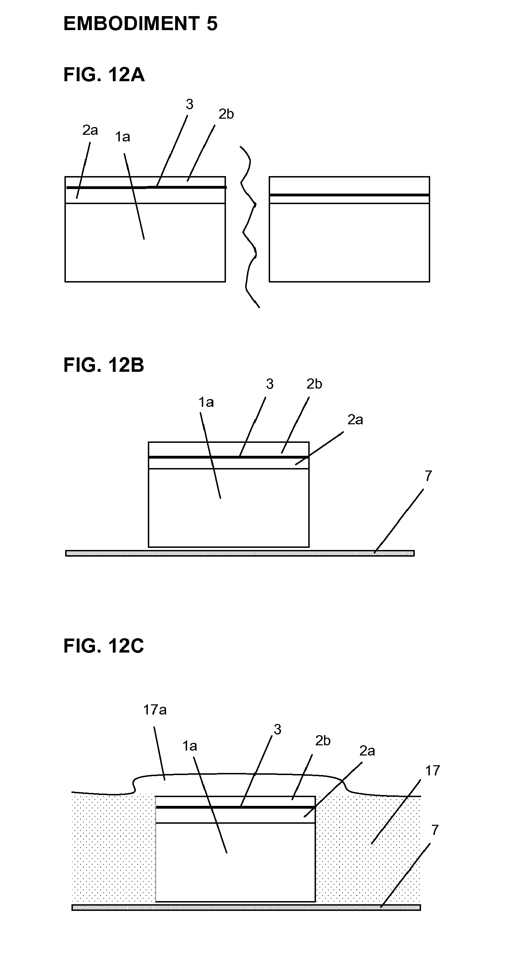

Referring to **FIG. 12A****,** the process begins with dicing/singulating the LED wafer, which consists of sapphire substrate **1a**, an n-type layer **2a,** an active region **3,** and a p-type layer **2b.** It is desirable to have all the mesa structures and *p*- and *n*- electrode formed on the LED wafer prior to the singulation process. This is a standard process and will not therefore be described. Stealth or ablation laser are typical methods used to cut through the sapphire substrate.

In **FIG. 12B****,** the singulated LED chip is then mounted onto the LED package base **7** using epoxy. The mounting process can be performed for a single LED chip or a series of LED chips forming an array, as in the case of high power LED modules. Note that the LED chips can also be mounted on a sacrificial substrate, in order to aid the sidewall formation process, and can later be removed.

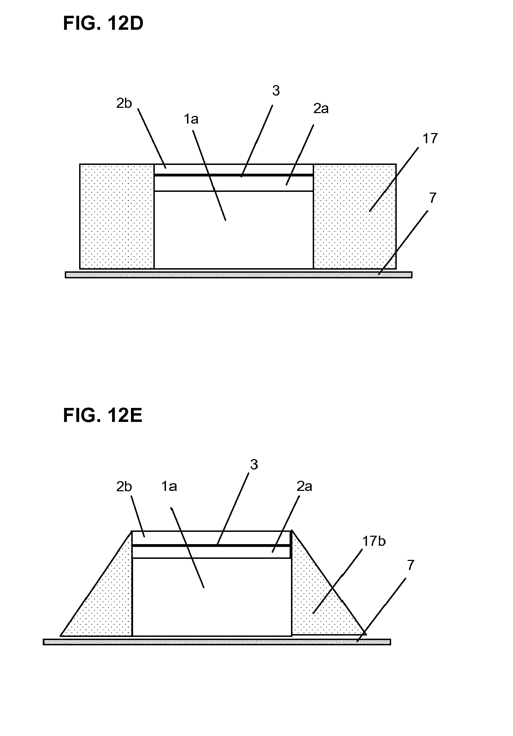

Referring to **FIG. 12C****,** a filler material, such as a transparent high index liquid/resin, is then deposited (e.g., spun) onto the substrate to form a transparent layer, the transparent layer being a material different from the LED chip or having a refractive index different from a refractive index of the LED chip. Due to the nature of spin-coating process, the entire structure would be semi-planarised and resin thickness above the LED chip **17a** will be much thinner than the resin directly above the reflector base **17.** In **FIG. 12D****,** the structure is then exposed to a dry or wet etching process to remove the resin portion **17a** above the LED chip. The resin can be cured at this stage to make it more stable and robust.

Referring to **FIG. 12E****,** the sidewalls of the LED chips is then shaped to form a tapered outwards structure **17b.** It can be shaped mechanically using bevel-shaped blades (i.e., a mechanical process), or laser dicing processes such as ablation/stealth dicing (i.e., an optical process). Dry/Wet etching process can also be used in the formation of structure **17b.**

### Embodiment 6:

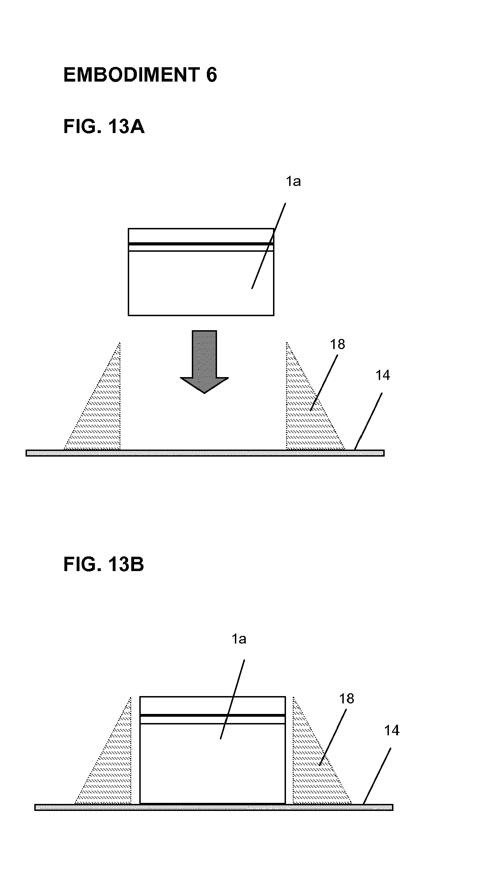

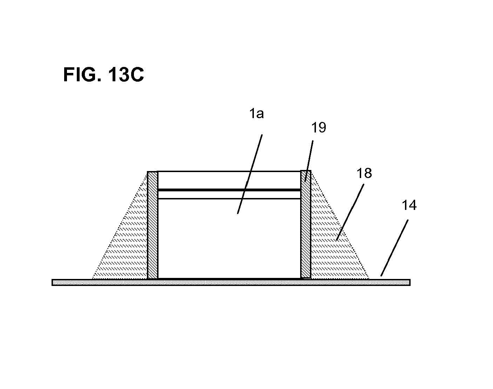

This embodiment describes the manufacturing method of embodiment 3 where sidewall structures are formed on an LED package base, the sidewall structures spaced apart from one another. Referring to **FIG. 13A****,** the LED package **14** with pre-formed tapered outwards structures **18** (e.g., preformed sidewalls) is prepared, which resembles pocket-like structures. These pockets can be of any height, but is preferably similar to the LED chip height. For example, a high power LED module may consist of 50 LED chips, hence 50 pocket-like structures are formed on the LED module package. Conventional LED chips with straight sidewalls (e.g., non-tapered sidewalls, parallel sidewalls, etc.) are then inserted and mounted into these pocket structures, as illustrated in **FIG. 13****B.** The LEDs in the module can then be connected using wire bonding. This process may not result in intimate contact between the LED chip and the pockets, hence resin **19 (****FIG. 13C****)** which is preferably index matching to either the LED host substrate **1a** or preformed sidewall **18** can be deposited to fill any gaps/voids between them. An LED with a tapered outwards sidewall is then achieved, without the need of shaping the post-processed LED chip.

A method for forming an LED device includes: mounting an LED chip onto an LED package base (14), the LED chip including a substrate (1), n-type layer (2a), active region (3), and p-type layer (2b); depositing a transparent layer (6) onto the substrate , said transparent layer being a material different from the LED chip or having a refractive index different from a refractive index of the LED chip; and shaping the sidewalls of the transparent layer to form a tapered outwards sidewall profile. Depositing the transparent layer can include using a resin to form the transparent layer, and/or curing the transparent layer. Mounting the LED chip can include mounting the LED chip on a sacrificial substrate, and/or mounting a single LED chip or an array of LED chips. Shaping the sidewalls can include shaping via a mechanical process, an optical process, or an etching process.

A method for creating an LED device includes: forming sidewall structures (13) on an LED package base (14), said sidewall structures spaced apart from one another and comprising a tapered outwards sidewall profile; and inserting an LED chip between adjacent formed sidewall structures, said LED chip comprising non-tapered sidewalls. The method can further include depositing a filler material between the LED chip and sidewall structures adjacent to the LED chip. Depositing the filler material can include depositing a resin that is index matching to one of an LED host substrate of the LED chip or the sidewall structures.

Although the invention has been shown and described with respect to certain preferred embodiments, it is obvious that equivalents and modifications will occur to others skilled in the art upon the reading and understanding of the specification. The present invention includes all such equivalents and modifications, and is limited only by the scope of the following claims.

### INDUSTRIAL APPLICABILITY

The invention thereby provides an LED device with tapered outwards structure, resulting in a higher ratio of forward over backward emission. The tapered structure is formed in such a way that active LED area is not lost, thus without compromising manufacturing costs. The invention further provides two methods of producing the same.

## Claims

1. A light emitting diode (LED), comprising:
a host substrate (1) formed from a first material;
an n-type layer (2a) formed over the host substrate;
an active region (3) formed over the n-type layer;
a p-type layer (2b) formed over the active region; and
a layer (6) formed adjacent to the host substrate and comprising a second material, the second material being different from the first material or having a refractive index different from a refractive index of the first material, wherein the second material is formed with a tapered outwards sidewall profile.

2. The LED according to claim 1, wherein a refractive index of the second material (6) is within 0.1 of a refractive index of the first material.

3. The LED according to any one of claims 1-2, wherein a refractive index of the second material (6) is at least 0.1 less than a refractive index of the first material.

4. The LED according to any one of claims 1-3, wherein a refractive index of the second material (6) is at least 0.5 less than a refractive index of first material.

5. The LED according to any one of claims 1-4, further comprising a base layer, (14) wherein the host substrate (1) is arranged over the base layer, and the second material (13) is pre-formed on the base layer prior to the host substrate being arranged over the base layer.

6. The LED according to claim 5, wherein the base layer (14) and the second material (6, 13) are formed from at least one of the same materials or different materials.

7. The LED according to any one of claims 1-6, wherein a refractive index of the second material (6, 13) is defined by a series of different refractive index materials.

8. The LED according to any one of claims 1-7, wherein the second material (6, 13) is formed from a plurality of different materials each having a refractive index, the plurality of different materials arranged one over the other from a high refractive index material to a low refractive index material, and wherein a refractive index of the host substrate is referenced as the high index material.

9. The LED according to any one of claims 1-8, wherein the tapered outwards sidewall profile comprises a trapezium-like shape.

10. The LED device according to any one of claims 1-9, wherein the second material (6) is formed from an optically transparent material.

11. The LED device according to any one of claims 1-10, wherein a refractive index of the second material (6) is between 1.6 - 1.8 at 450nm.

12. The LED device according to any one of claims 1-11, wherein the tapered outwards sidewall profile comprises an air gap surrounded by epoxy or resin.

13. A method for forming an LED device, comprising:
mounting an LED chip onto an LED package base (14), the LED chip including a substrate (1), n-type layer (2a), active region (3), and p-type layer (2b);
depositing a transparent layer (6) onto the substrate , said transparent layer being a material different from the LED chip or having a refractive index different from a refractive index of the LED chip; and
shaping the sidewalls of the transparent layer to form a tapered outwards sidewall profile.

14. The method according to claim 13, further comprising removing a portion of the transparent layer that lies over the LED chip.

15. The method according to claim 14, wherein removing includes removing the portion via an etching process.
